# FASCICULE DE BREVET EUROPEEN

(11) **EP 3 391 413 B1**
(45) Date de publication et mention de la délivrance du brevet: **11.12.2019**
(21) Numéro de dépôt: 16810410.7
(22) Date de dépôt: 16.12.2016
(51) Int. Cl.: H01L 27/146, H01L 31/101

(54) **ELÉMENT DÉTECTEUR DE RAYONNEMENT ET IMAGEUR COMPRENANT UN ENSEMBLE D'ÉLÉMENTS DÉTECTEURS DE RAYONNEMENT**
STRAHLUNGSDETEKTORELEMENT UND BILDGEBER MIT EINER ANORDNUNG VON STRAHLUNGSDETEKTORELEMENTEN
RADIATION DETECTOR ELEMENT AND IMAGER COMPRISING AN ASSEMBLY OF RADIATION DETECTOR ELEMENTS

(30) Priorité: 16.12.2015 FR 1502616
(43) Date de publication de la demande: 24.10.2018
(73) Titulaire: Thales, 92400 Courbevoie (FR); Commissariat à l'Énergie Atomique et aux Énergies Alternatives, 75015 Paris (FR)
(72) Inventeur: LEGOFF, Florian, 91767 Palaiseau Cedex (FR); REVERCHON, Jean-Luc, 91767 Palaiseau Cedex (FR); KAZMIERSKI, Christophe, 91767 Palaiseau Cedex (FR); DECOBERT, Jean, 91767 Palaiseau Cedex (FR)
(74) Mandataire: Lavoix
(86) Numéro de dépôt international: PCT/EP2016/081514
(87) Numéro de publication internationale: WO 2017/103161

(56) Documents cités:
- EP-A2- 2 432 034
- FR-A1- 2 983 348
- US-A1- 2012 273 838

## Description

La présente invention concerne un élément détecteur de rayonnement, ainsi qu'un imageur comprenant un ensemble d'éléments détecteurs de rayonnement.

Généralement, des dispositifs détecteurs de rayonnement électromagnétique comprennent une matrice d'éléments détecteurs de rayonnement individuels. De tels dispositifs détecteurs de rayonnement, aussi dénommés « imageurs », comprennent, en outre, un circuit de lecture apte à recevoir de chaque élément détecteur de rayonnement un signal électrique. L'imageur est propre à reconstituer une image bidimensionnelle à partir des signaux électriques fournis par chaque élément détecteur.

Les éléments détecteurs de rayonnement utilisés sont fréquemment réalisés dans des matériaux semi-conducteurs. Par exemple, des éléments détecteurs de rayonnement en silicium du type CCD (de l'anglais « Charge-Coupled Device », pour « Dispositif à Transfert de Charge ») ou CMOS (pour « Complementary Metal-Oxide-Semiconductor », pour « semi-conducteur à oxyde de métal complémentaire ») sont utilisés dans les appareils photographiques numériques aptes à détecter un rayonnement électromagnétique visible. Pour d'autres gammes de rayonnements, telles que les rayonnements infrarouges, d'autres types d'éléments détecteurs de rayonnement sont utilisés, par exemple comprenant des photodiodes.

Les éléments détecteurs à photodiode comprennent une couche propre à absorber le rayonnement, réalisée dans un matériau semi-conducteur. La couche absorbante comprend une jonction p/n formée de la juxtaposition d'une portion de matériau dopé p et d'une portion de matériau dopé n. Une telle jonction p/n génère dans la couche absorbante un champ électrique. Lorsqu'un photon est absorbé, il génère dans la couche absorbante une paire électron-trou. Le champ électrique exerce sur l'électron et le trou une force qui sépare la paire électron-trou, et donne naissance à un courant électrique. Le courant électrique est ensuite détecté par un circuit de lecture dédié. Le document FR 2 983 348 décrit un bloc détecteur optique de type hybride.

Il est connu de l'article de I.M Baker, intitulé « Hybrid CdHgTe-Silicon infrared focal plane arrays » et paru en 1990 dans « Fourth International Conférence on Advanced Infrared Detectors and Systems », pages 78 à 87, un élément détecteur de ce type, comprenant une couche absorbante semi-conductrice traversée par une électrode. L'électrode est entourée par une première portion de la couche absorbante présentant un dopage de type n. Une deuxième portion de la couche absorbante présente un dopage de type p. La première portion est cylindrique, et forme, avec la deuxième portion, une jonction n/p entourant l'électrode. Une telle géométrie d'éléments détecteurs est dénommée «loop-hole».

Lors du fonctionnement d'un élément détecteur, le courant électrique traverse successivement une électrode, la première portion, la jonction p/n, puis la deuxième portion avant de rejoindre le circuit de lecture.

Cependant, de tels éléments détecteurs présentent souvent une résistance importante au passage du courant. Par exemple, l'élément détecteur présente une résistance de l'ordre de 10¹¹ Ohm (Ω) à 10¹⁴ Ω, qui s'additionne à une résistance dite d'accès de l'ordre de 10⁶ Ω entre l'élément détecteur et le contact électrique. Il en découle que, lorsqu'un imageur comprend plusieurs éléments détecteurs partageant un contact électrique commun, les éléments détecteurs ne présentent pas tous la même résistance électrique au passage du courant. En particulier, la résistance électrique augmente avec la distance entre l'élément détecteur et le contact électrique. Ce phénomène est fréquemment nommé « dépolarisation ».

Afin de limiter la dépolarisation, la deuxième portion est, en général, connectée électriquement au circuit de lecture par une couche métallique placée à sa surface. Cependant, la couche métallique absorbe en général une partie du rayonnement à détecter. Le rendement de l'élément détecteur n'est donc pas optimisé.

Il existe donc un besoin pour un élément détecteur de rayonnement présentant un meilleur rendement.

A cet effet, il est proposé un élément détecteur de rayonnements comprenant :
- un empilement de couches superposées selon une direction d'empilement, l'empilement présentant une première face et une deuxième face et comprenant une couche absorbante de rayonnement réalisée en un premier matériau semi-conducteur présentant une première valeur de gap et au moins une couche barrière réalisée en un deuxième matériau semi-conducteur présentant une deuxième valeur de gap, la deuxième valeur de gap étant supérieure strictement à la première valeur de gap ; et
- un circuit de lecture délimité selon la direction d'empilement par la première face ;
la couche absorbante comprenant une première portion présentant un dopage d'un premier type choisi parmi le dopage de type n et le dopage de type p, et une deuxième portion présentant un dopage d'un deuxième type choisi parmi le dopage de type n et le dopage de type p, le deuxième type de dopage étant différent du premier type de dopage, la première portion et la deuxième portion formant une première jonction p-n ;
l'empilement délimitant en outre un trou primaire traversant chacune des couches de l'empilement, le trou primaire accueillant au moins en partie une électrode primaire connectant électriquement la deuxième portion au circuit de lecture et traversant la première face, la première jonction p-n entourant l'électrode primaire dans un plan orthogonal à la direction d'empilement, et
la deuxième face portant au moins une bande délimitée selon la direction d'empilement par la couche barrière, la bande étant réalisée en le deuxième matériau semi-conducteur et présentant un dopage du premier type et une densité de porteurs libres supérieure ou égale à 1.10¹⁷cm⁻³.

Suivant un mode de réalisation particulier, l'élément détecteur comprend une ou plusieurs des caractéristiques suivantes, prise(s) isolément ou selon toutes les combinaisons techniquement possibles :
- la bande est réalisée en un matériau semi-conducteur dégénéré.
- la bande entoure l'électrode primaire dans un plan orthogonal à la direction d'empilement.
- l'empilement comprend, en outre, au moins une couche intermédiaire réalisée en un troisième matériau semi-conducteur ayant une troisième valeur de gap comprise entre la première valeur de gap et la deuxième valeur de gap, la couche intermédiaire étant délimitée, selon la direction d'empilement, par la couche absorbante et la couche barrière.
- le troisième matériau est un matériau quaternaire au moins formé à partir du premier matériau et du deuxième matériau.
- le premier matériau est choisi parmi InGaAs, InAsSb et InSb, et lorsque le premier matériau est InGaAs le deuxième matériau est InP, lorsque le premier matériau est InAsSb le deuxième matériau est AIGaAsSb, et lorsque le premier matériau est InSb le deuxième matériau est InAISb.
- l'élément détecteur comporte en outre une couche de passivation entourant dans un plan orthogonal à la direction d'empilement l'électrode primaire, la couche de passivation étant délimitée dans le plan orthogonal à la direction d'empilement par l'électrode primaire et par la couche barrière, la couche de passivation étant propre à isoler électriquement la couche barrière de l'électrode primaire.
- le trou primaire est en forme de cône à base circulaire.

Il est également proposé un imageur comprenant au moins un deuxième ensemble d'éléments détecteurs de rayonnements tel que défini ci-dessus, dans lequel chaque bande est connectée électriquement à au moins une autre bande, les bandes formant, sur la deuxième face, un réseau bidimensionnel présentant une pluralité de mailles, chaque maille entourant, dans un plan orthogonal à la direction d'empilement, une unique électrode primaire.

Suivant un mode de réalisation particulier, l'imageur comprend une couche de collection réalisée en le deuxième matériau et recouvrant en partie la deuxième face, le dispositif comprenant, en outre, un premier ensemble de trous secondaires, chaque trou secondaire traversant la couche de collection et accueillant au moins en partie une première électrode traversant la première face et connectant électriquement la couche de collection au circuit de lecture.

Il est également proposé un élément détecteur de rayonnements comprenant un empilement de couches superposées selon une direction d'empilement, l'empilement comportant une première face et une deuxième face et comprenant une couche absorbante de rayonnement réalisée en un premier matériau semi-conducteur présentant une première valeur de gap et au moins une couche barrière réalisée en un deuxième matériau semi-conducteur présentant une deuxième valeur de gap, la deuxième valeur de gap étant supérieure strictement à la première valeur de gap. L'élément détecteur de rayonnements comprend un circuit de lecture délimité selon la direction d'empilement par la première face. La couche absorbante comprend une première portion présentant un dopage d'un premier type choisi parmi le dopage de type n et le dopage de type p, et une deuxième portion présentant un dopage d'un deuxième type choisi parmi le dopage de type n et le dopage de type p, le deuxième type de dopage étant différent du premier type de dopage, la première portion et la deuxième portion formant une première jonction p/n. La couche barrière comporte une première zone conductrice présentant un dopage du premier type, la première zone conductrice et la première portion étant superposées. L'empilement délimite en outre un trou primaire traversant chacune des couches de l'empilement, le trou primaire accueillant au moins en partie une électrode primaire connectant électriquement la deuxième portion au circuit de lecture et traversant la première face, la première jonction p/n entourant l'électrode primaire dans un plan orthogonal à la direction d'empilement, et la première zone conductrice présentant une densité de porteurs libres supérieure ou égale à 1.10¹⁷cm⁻³.

Suivant un mode de réalisation particulier, l'élément détecteur comprend une ou plusieurs des caractéristiques suivantes, prise(s) isolément ou selon toutes les combinaisons techniquement possibles :
- la première zone conductrice est réalisée en un matériau semi-conducteur dégénéré.
- l'empilement comprend, en outre, au moins une couche intermédiaire réalisée dans un troisième matériau semi-conducteur ayant une troisième valeur de gap comprise entre la première valeur de gap et la deuxième valeur de gap, la couche intermédiaire étant délimitée, selon la direction d'empilement, par la couche absorbante et la couche barrière.
- le troisième matériau est un matériau quaternaire au moins formé à partir du premier matériau et du deuxième matériau.
- la couche barrière comporte une deuxième zone conductrice présentant un dopage du deuxième type, la première zone conductrice et la deuxième zone conductrice formant une deuxième jonction p/n entourant l'électrode primaire dans un plan orthogonal à la direction d'empilement et la deuxième zone conductrice étant en contact avec l'électrode primaire.
- le premier matériau est choisi parmi InGaAs, InAsSb et InSb, et lorsque le premier matériau est InGaAs le deuxième matériau est InP, lorsque le premier matériau est InAsSb le deuxième matériau est AIGaAsSb, et lorsque le premier matériau est InSb le deuxième matériau est InAISb.
- l'élément détecteur comporte en outre une couche de passivation entourant dans un plan orthogonal à la direction d'empilement l'électrode primaire, la couche de passivation étant délimitée dans le plan orthogonal à la direction d'empilement par l'électrode primaire et par la couche barrière, la couche de passivation étant propre à isoler électriquement la couche barrière de l'électrode primaire ;
- l'élément détecteur comporte en outre une couche filtrante propre à permettre la propagation d'au moins une onde électromagnétique présentant une première énergie comprise dans un ensemble primaire d'énergies et à empêcher la propagation d'au moins une onde électromagnétique présentant une deuxième énergie comprise dans un ensemble secondaire d'énergies, l'ensemble secondaire étant différent de l'ensemble primaire, la couche filtrante étant délimitée selon la direction d'empilement par la deuxième face.
- le trou primaire est en forme de cône à base circulaire.
- la première zone conductrice présente un gradient spatial de dopage selon la direction d'empilement.

Il est également proposé un imageur comprenant au moins un deuxième ensemble de d'éléments détecteurs de rayonnement tel que défini précédemment, l'imageur comprenant en outre un premier ensemble de trous secondaires accueillant chacun au moins en partie une électrode secondaire connectant électriquement la première zone conductrice au circuit de lecture et traversant la première face, chacun des trous secondaires du premier ensemble étant disposé le long d'une ligne propre du premier ensemble, et la ligne propre entourant le deuxième ensemble dans un plan orthogonal à la direction d'empilement.

Des caractéristiques et avantages de l'invention apparaîtront à la lecture de la description qui va suivre, donnée uniquement à titre d'exemple non limitatif, et faite en référence aux dessins annexés, sur lesquels :
- les figures 1 à 3 sont des vues en coupe d'un élément détecteur de rayonnement,
- la figure 4 est une représentation schématique de dessus d'un imageur comprenant un ensemble d'éléments détecteurs selon la figure 1,
- la figure 5 est une vue en coupe d'une variante de l'élément détecteur de la figure 1,
- les figures 6 et 7 sont des représentations schématiques de dessus d'un imageur comprenant un ensemble d'éléments détecteurs selon la figure 5.

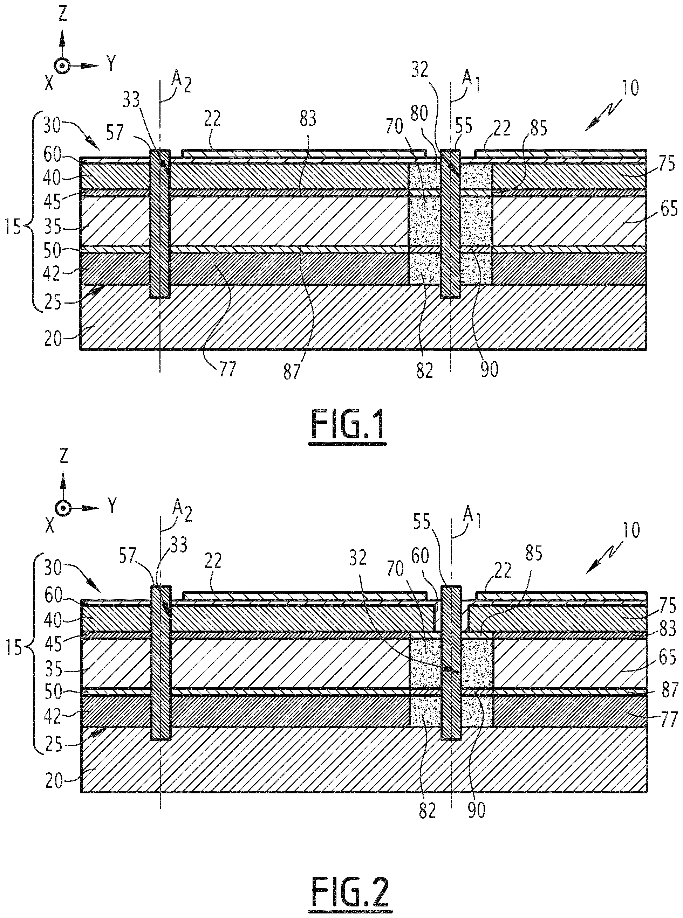

Un premier exemple d'élément détecteur 10 de rayonnement est représenté sur la figure 1.

L'élément détecteur 10 est propre à générer un signal électrique S lorsque l'élément détecteur 10 absorbe un rayonnement R.

Le rayonnement R comprend au moins une onde électromagnétique Oe.

L'onde électromagnétique Oe présente au moins une énergie E et une amplitude A.

L'énergie E est définie comme étant le produit de la constante de Planck *h* et de la fréquence f de l'onde électromagnétique Oe dans le vide.

L'amplitude A est définie comme étant la norme euclidienne du champ électrique de l'onde électromagnétique Oe.

Le signal électrique S est un courant électrique. Par exemple, le signal électrique S est un courant électrique proportionnel à l'amplitude A de l'onde électromagnétique Oe.

L'élément 10 détecteur de rayonnement comprend un empilement 15 de couches superposées et un circuit de lecture 20. Optionnellement, comme c'est le cas pour l'exemple de la figure 1, l'élément détecteur 10 comprend également une couche filtrante 22.

L'empilement 15 comprend une pluralité de couches superposées selon une direction d'empilement Z.

L'empilement 15 présente une première face 25 et une deuxième face 30, et délimite un trou primaire 32 et un trou secondaire 33.

L'empilement 15 est délimité selon la direction d'empilement Z par la première face 25 et la deuxième face 30.

L'empilement 15 comprend une couche absorbante 35, une première couche barrière 40, une deuxième couche barrière 42, une première couche intermédiaire 45, une deuxième couche intermédiaire 50, une électrode primaire 55, une électrode secondaire 57 et une couche de passivation 60.

Le circuit de lecture 20 est configuré pour générer le signal électrique S en réponse à un courant électrique C reçu de l'électrode primaire 55.

Le circuit de lecture 20 est délimité selon la direction d'empilement Z par la première face 25. Le circuit de lecture 20 est connecté électriquement à l'électrode primaire 55.

La couche filtrante 22 est propre à permettre la propagation, selon la direction d'empilement Z, d'au moins une onde électromagnétique Oe présentant une énergie E comprise dans un ensemble primaire En1 d'énergies.

La couche filtrante 22 est propre à empêcher la propagation, selon la direction d'empilement Z, d'au moins une onde électromagnétique Oe présentant une énergie E comprise dans un ensemble secondaire En2 d'énergies.

L'ensemble secondaire En2 est différent de l'ensemble primaire En1. Cela signifie qu'il existe au moins une énergie E comprise dans l'ensemble primaire En1, et n'étant pas comprise dans le l'ensemble secondaire En2.

La couche filtrante 22 présente une première épaisseur e1 selon la direction d'empilement Z.

La couche filtrante 22 est planaire.

Cela signifie que la première épaisseur e1 est uniforme. Il est entendu par l'expression « épaisseur uniforme » d'une couche que, lorsque l'épaisseur est définie comme étant la longueur d'un segment parallèle à la direction d'empilement Z et reliant un premier point d'une première surface de la couche à un deuxième point d'une deuxième surface de la couche, l'épaisseur est inchangée, à dix pourcents près, lorsque la position du premier point sur la première surface est modifiée.

La couche présente, en outre, une largeur selon une première direction X perpendiculaire à la direction d'empilement, et une longueur selon une deuxième direction Y perpendiculaire à la première direction X et à la direction d'empilement Z. Il est également entendu par le terme « couche planaire » que la longueur et la largeur de la couche filtrante sont, chacune, supérieures strictement à dix fois la première épaisseur e1.

La couche filtrante 22 est perpendiculaire à la direction d'empilement Z. Cela signifie que la première direction de la couche filtrante 22 est la direction d'empilement Z.

La couche filtrante 22 est délimitée selon la direction d'empilement Z par la couche de passivation 60.

La couche filtrante 22 comporte un empilement de couches diélectriques. Par exemple la couche filtrante 22 est un réseau de Bragg, c'est-à-dire un empilement de couches diélectriques d'indices optiques différents telles que l'oxyde de titane TiO2 et l'oxyde de silicium SiO2.

En variante, la couche filtrante 22 est une couche d'un matériau polymère chargé. Par exemple la couche filtrante 22 est réalisée en un polyimide comprenant des charges d'un composé aromatique présentant un spectre d'absorption spécifique.

Le trou primaire 32 traverse chacune des couches de l'empilement 15.

Le trou primaire 32 accueille au moins en partie l'électrode primaire 55.

Le trou primaire 32 est cylindrique à base circulaire.

Le trou primaire 32 présente un premier axe A1.

Le premier axe A1 est, de préférence, parallèle à la direction d'empilement Z.

Le trou secondaire 33 traverse chacune des couches de l'empilement 15. Le trou secondaire 33 accueille au moins en partie l'électrode secondaire 57.

Sur la figure 1, le trou secondaire 33 est cylindrique à base circulaire.

Le trou secondaire 33 présente un deuxième axe A2. Le deuxième axe A2 est, de préférence, parallèle à la direction d'empilement Z.

La couche absorbante 35 est propre à absorber au moins en partie le rayonnement R.

La couche absorbante 35 est réalisée dans un premier matériau semi-conducteur M1 présentant une première valeur de gap G1.

Il est entendu par «valeur de gap» d'un matériau la valeur de la largeur de la bande interdite entre la bande de valence et la bande de conduction dans le matériau. La valeur de gap d'un matériau est, par exemple, exprimée en électron-volts (eV).

La bande de valence est définie comme étant, parmi les bandes d'énergie permises pour un électron dans le matériau, la bande qui présente l'énergie la plus haute tout en étant remplie complètement à une température inférieure ou égale à 20 kelvins (K).

La bande de conduction est définie comme étant, parmi les bandes d'énergie permises pour un électron dans le matériau, la bande qui présente l'énergie la plus basse tout en n'étant pas remplie à une température inférieure ou égale à 20 K.

Il est entendu par « matériau semi-conducteur » un matériau présentant une valeur de gap strictement supérieure à zéro et inférieure ou égale à 6.5 eV.

Le premier matériau M1 est, par exemple, un matériau binaire tel que l'antimoniure d'indium InSb.

En variante, le premier matériau semi-conducteur est un matériau ternaire tel que l'arséniure d'indium et de gallium InGaAs ou l'antimoniure-arséniure d'indium InAsSb.

La couche absorbante 35 comprend une première portion 65 et une deuxième portion 70.

La couche absorbante 35 est planaire. La couche absorbante 35 est, de préférence, perpendiculaire à la direction d'empilement Z.

La couche absorbante 35 est délimitée, selon la direction d'empilement Z, par la première couche intermédiaire 45 et par la deuxième couche intermédiaire 50.

La couche absorbante 35 présente une deuxième épaisseur e2 selon la direction d'empilement Z. La deuxième épaisseur e2 est, par exemple, comprise entre 1 µm et 3 µm.

La première portion 65 présente un dopage d'un premier type.

Le dopage est défini comme étant la présence, dans un matériau, d'impuretés apportant des porteurs de charge libres. Les impuretés sont, par exemple, des atomes d'un élément qui n'est pas présent naturellement dans le matériau.

Lorsque la présence des impuretés augmente la densité volumique de trous présents dans le matériau par rapport au matériau non dopé, le dopage est de type p. Par exemple, une couche d'InP est dopée p par l'adjonction d'atomes de zinc.

Lorsque la présence des impuretés augmente la densité volumique d'électrons libres présents dans le matériau par rapport au matériau non dopé, le dopage est de type n. Par exemple, une couche d'InP est dopée n par l'adjonction d'atomes de soufre.

Le premier type de dopage est choisi parmi le dopage de type n et le dopage de type p.

Par exemple, le premier type de dopage est le dopage de type n.

La première portion 65 présente une première densité volumique d1 de porteurs.

La densité volumique de porteurs est définie, pour un matériau dopé n, comme étant le nombre d'électrons libres dans le matériau par unité de volume.

La densité volumique de porteurs est définie, pour un matériau dopé p, comme étant le nombre de trous par unité de volume.

La première densité volumique d1 de porteurs est uniforme. Cela signifie que, si la première densité volumique de porteurs d1 est mesurée, par exemple par tomographie électronique, en différents emplacements de la première portion 65, la valeur mesurée varie de moins de dix pourcents selon l'emplacement dans la première portion 65 où la mesure est effectuée.

La première densité volumique de porteurs d1 est, par exemple, égale à 5.10¹⁸ par centimètre cube (/cm³), où « . » désigne l'opération mathématique de multiplication.

La première portion 65 est annulaire à base circulaire. La première portion 65 est annulaire autour du premier axe A1.

La première portion 65 entoure, dans un plan perpendiculaire à la direction d'empilement Z, la deuxième portion 70 et l'électrode primaire 55.

La deuxième portion 70 présente un dopage d'un deuxième type.

Le deuxième type de dopage est choisi parmi le dopage p et le dopage n. Le deuxième type de dopage est différent du premier type de dopage.

Lorsque la première portion 65 présente un dopage de type n, la deuxième portion 70 présente un dopage de type p. Lorsque la première portion 65 présente un dopage de type p, la deuxième portion 70 présente un dopage de type n.

La première portion 65 est annulaire à base circulaire. La première portion 65 présente une symétrie de révolution autour du premier axe A1.

La deuxième portion 70 présente une deuxième densité volumique de porteurs d2.

La deuxième densité volumique de porteurs d2 est, par exemple, comprise strictement entre 5.10¹³/cm³ et 1.10¹⁶/cm³.

La deuxième portion 70 est cylindrique à base circulaire. La deuxième portion 70 présente une symétrie de révolution autour du premier axe A1.

La deuxième portion 70 entoure, dans un plan perpendiculaire à la direction d'empilement Z, l'électrode primaire 55.

La première portion 65 et la deuxième portion 70 forment une première jonction p/n J1.

Une jonction p/n est définie comme étant l'interface entre deux portions de matériau semi-conducteur présentant respectivement un dopage de type p et un dopage de type n.

La première jonction p/n J1 entoure, dans un plan perpendiculaire à la direction d'empilement Z, l'électrode primaire 55.

Par exemple, la première jonction p/n J1 est cylindrique à base circulaire autour du premier axe A1.

La première jonction p/n J1 génère un premier champ électrique C1.

La première couche barrière 40 est propre à isoler de l'extérieur la couche absorbante 35. La première couche barrière 40 est, en outre, propre à empêcher un porteur de charge de rejoindre la deuxième face 30 depuis la couche absorbante 35.

La première couche barrière 40 est réalisée en un deuxième matériau semi-conducteur M2.

Le deuxième matériau semi-conducteur M2 présente une deuxième valeur de gap G2. La deuxième valeur de gap G2 est supérieure strictement à la première valeur de gap G1.

Par exemple, lorsque le premier matériau M1 est InGaAs, le deuxième matériau M2 est le phosphure d'indium InP.

En variante, lorsque le premier matériau M1 est InAsSb, le deuxième matériau M2 est l'arséniure-antimoniure d'aluminium et de gallium AIGaAsSb.

Dans une autre variante, lorsque le premier matériau M1 est InSb, le deuxième matériau M2 est l'antimoniure d'indium et d'aluminium InAISb.

La première couche barrière 40 est planaire. La première couche barrière 40 est, de préférence, perpendiculaire à la direction d'empilement Z.

La première couche barrière 40 est délimitée selon la direction d'empilement Z par la première couche intermédiaire 45 et par la couche de passivation 60.

La première couche barrière 40 présente une troisième épaisseur e3 selon la direction d'empilement Z. La troisième épaisseur e3 est, par exemple, comprise entre 50 nanomètres (nm) et 1 µm, par exemple égale à 300 nm.

La première couche barrière 40 comporte une première zone conductrice 75 et une deuxième zone conductrice 80.

La première zone conductrice 75 est annulaire à base circulaire. La première zone conductrice 75 présente une symétrie circulaire autour du premier axe A1.

La première zone conductrice 75 entoure, dans un plan perpendiculaire à la direction d'empilement Z, la deuxième zone conductrice 80 et l'électrode primaire 55.

La première zone conductrice 75 et la première portion 65 sont superposées.

La première zone conductrice 75 présente un dopage du premier type.

La première zone conductrice 75 présente une troisième densité volumique de porteurs d3.

La troisième densité volumique de porteurs d3 est, par exemple, uniforme. La troisième densité volumique de porteurs d3 est supérieure ou égale à 10¹⁷/cm³.

En variante, la première zone conductrice 75 est réalisée en un deuxième matériau semi-conducteur M2 dégénéré.

Cela signifie que la première zone conductrice 75 est fortement dopée et présente les mêmes caractéristiques électriques qu'un matériau conducteur. En particulier, la conductivité électrique de la première zone conductrice 75 ne varie pas en fonction de la température.

Par exemple, lorsque la première zone conductrice 75 est réalisée en InP et présente un dopage de type n, la première zone conductrice 75 est dégénérée lorsque la troisième densité volumique de porteurs d3 est supérieure ou égale à 2.10¹⁷/cm³.

En variante, la première zone conductrice 75 présente un gradient de dopage selon la direction d'empilement Z. Cela signifie que la troisième densité volumique de porteurs d3 varie de façon monotone selon la direction d'empilement Z.

De préférence, la troisième densité volumique de porteurs d3 augmente, selon la direction d'empilement Z, en s'éloignant de la couche absorbante 35.

Par exemple, la troisième densité volumique de porteurs d3 est égale, à l'interface entre la première zone conductrice 75 et la première couche intermédiaire 45, à 2.10¹⁶/cm³, et est égale à 5.10¹⁷/cm³ à l'interface entre la première zone conductrice 75 et la couche de passivation 60.

La première zone conductrice 75 est connectée électriquement au circuit de lecture 20 par l'électrode secondaire 57.

La deuxième zone conductrice 80 présente un dopage du deuxième type.

La deuxième zone conductrice 80 présente une quatrième densité volumique de porteurs d4.

Par exemple, la quatrième densité volumique de porteurs d4 est comprise strictement entre 1.10¹⁶/cm³ et 5.10¹⁸/cm³.

La deuxième zone conductrice 80 est annulaire à base circulaire. La deuxième zone conductrice 80 présente une symétrie circulaire autour du premier axe A1.

La deuxième zone conductrice 80 entoure, dans un plan perpendiculaire à la direction d'empilement Z, l'électrode primaire 55.

La deuxième zone conductrice 80 et la deuxième portion 70 sont superposées.

La première zone conductrice 75 et la deuxième zone conductrice 80 forment une deuxième jonction p/n J2.

La deuxième jonction p/n J2 entoure l'électrode primaire 55 dans un plan perpendiculaire à la direction d'empilement Z.

La deuxième couche barrière 42 est propre à isoler de l'extérieur la couche absorbante 35. La deuxième couche barrière 42 est, en outre, propre à empêcher un porteur de charge de rejoindre la première face 25 depuis la couche absorbante 35.

La deuxième couche barrière 42 est réalisée en le deuxième matériau semi-conducteur M2.

La deuxième couche barrière 42 est planaire.

La deuxième couche barrière 42 est, de préférence, perpendiculaire à la direction d'empilement Z.

La deuxième couche barrière 42 est délimitée selon la direction d'empilement Z par la deuxième couche intermédiaire 50 et par la première face 25.

La deuxième couche barrière 42 présente une quatrième épaisseur e4 selon la direction d'empilement Z. La quatrième épaisseur e4 est comprise entre 50 nm et 1 µm, par exemple égale à 300 nm.

La deuxième couche barrière 42 comporte une troisième zone conductrice 77 et une quatrième zone conductrice 82.

La troisième zone conductrice 77 est annulaire à base circulaire. La troisième zone conductrice 77 présente une symétrie circulaire autour du premier axe A1.

La troisième zone conductrice 77 entoure, dans un plan perpendiculaire à la direction d'empilement Z, la quatrième zone conductrice 82 et l'électrode primaire 55.

La troisième zone conductrice 77 et la première portion 65 sont superposées.

La troisième zone conductrice 77 présente un dopage du premier type.

La troisième zone conductrice 77 présente une cinquième densité volumique de porteurs d5.

La cinquième densité volumique de porteurs d5 est, par exemple, uniforme.

Par exemple, la cinquième densité volumique de porteurs d5 est supérieure ou égale à 10¹⁷/cm³.

En variante, la cinquième densité volumique de porteurs d5 est égale à 2.10¹⁶/cm³.

La quatrième zone conductrice 82 présente un dopage du deuxième type.

La quatrième zone conductrice 82 et la troisième zone conductrice 77 forment une troisième jonction p/n J3. La troisième jonction p/n J3 entoure, dans un plan perpendiculaire à la direction d'empilement Z, l'électrode primaire 55.

La quatrième zone conductrice 82 présente une sixième densité volumique de porteurs d6.

La sixième densité volumique de porteurs d6 est, par exemple, comprise strictement entre 1.10¹⁶/cm³ et 5.10¹⁸/cm³.

La quatrième zone conductrice 82 et la deuxième portion 70 sont superposées.

La quatrième zone conductrice 82 est annulaire à base circulaire. La quatrième zone conductrice 82 présente une symétrie circulaire autour du premier axe A1.

La quatrième zone conductrice 82 entoure, dans un plan perpendiculaire à la direction d'empilement Z, l'électrode primaire 55.

La première couche intermédiaire 45 est propre à faciliter le transfert des porteurs de charge de la couche absorbante 35 à la première couche barrière 40. Cela signifie que, lorsqu'une différence de potentiel électrique est appliquée entre la couche absorbante 35 et la première couche barrière 40, la résistance électrique mesurée est inférieure à la résistance électrique mesurée en l'absence de la première couche intermédiaire 45.

La première couche intermédiaire 45 est planaire. La première couche intermédiaire 45 est, de préférence, perpendiculaire à la direction d'empilement Z.

La première couche intermédiaire 45 est délimitée, selon la direction d'empilement Z, par la couche absorbante 35 et la première couche barrière 40.

La première couche intermédiaire 45 présente une cinquième épaisseur e5 selon la direction d'empilement Z. La cinquième épaisseur e5 est comprise strictement entre 10 nm et 50 nm.

La première couche intermédiaire 45 est réalisée en un troisième matériau semi-conducteur M3.

Le troisième matériau semi-conducteur M3 présente une troisième valeur de gap G3.

La troisième valeur de gap G3 est strictement supérieure à la première valeur de gap G1.

La troisième valeur de gap G3 est strictement supérieure inférieure à la deuxième valeur de gap G2.

De préférence, le troisième matériau M3 est formé à partir du premier matériau M1 et du deuxième matériau M2.

Par exemple, lorsque le premier matériau M1 est InGaAs, et le deuxième matériau M2 est InP, le troisième matériau M3 est le matériau quaternaire arséniure-phosphure d'indium et de gallium InGaAsP.

La première couche intermédiaire 45 comporte une première zone intermédiaire 83 et une deuxième zone intermédiaire 85.

La première zone intermédiaire 83 présente un dopage du premier type.

La première zone intermédiaire 83 présente une septième densité volumique de porteurs d7.

La septième densité volumique de porteurs d7 est, par exemple, comprise strictement entre 1.10¹⁴/cm³ et 5.10¹⁷/cm³.

La première zone intermédiaire 83 et la première portion 65 sont superposées selon la direction d'empilement Z.

La première zone intermédiaire 83 est annulaire à base circulaire. La première zone intermédiaire 83 présente une symétrie circulaire autour du premier axe A1.

La première zone intermédiaire 83 entoure, dans un plan perpendiculaire à la direction d'empilement Z, la deuxième zone intermédiaire 85 et l'électrode primaire 55.

La deuxième zone intermédiaire 85 présente un dopage du deuxième type.

La deuxième zone intermédiaire 85 présente une huitième densité volumique de porteurs d8.

La huitième densité volumique de porteurs d8 est, par exemple, comprise strictement entre 1.10¹⁶/cm³ et 5.10¹⁸/cm³.

La deuxième zone intermédiaire 85 et la deuxième portion 70 sont superposées selon la direction d'empilement Z.

La deuxième zone intermédiaire 85 est annulaire à base circulaire. La deuxième zone intermédiaire 85 présente une symétrie circulaire autour du premier axe A1.

La deuxième zone intermédiaire 85 entoure, dans un plan perpendiculaire à la direction d'empilement Z, l'électrode primaire 55.

La première zone d'intermédiaire 83 et la deuxième zone intermédiaire 85 forment une quatrième jonction p/n J4.

La quatrième jonction p/n J4 entoure, dans un plan perpendiculaire à la direction d'empilement Z, l'électrode primaire 55.

La quatrième jonction p/n J4 est, par exemple, cylindrique à base circulaire autour du premier axe A1.

La deuxième couche intermédiaire 50 est propre à faciliter le transfert des porteurs de charge de la couche absorbante 35 à la deuxième couche barrière 42. Cela signifie que, lorsqu'une différence de potentiel électrique est appliquée entre la couche absorbante 35 et la deuxième couche barrière 42, la résistance électrique au passage du courant est inférieure à la résistance électrique mesurée en l'absence de la deuxième couche intermédiaire 50.

La deuxième couche intermédiaire 50 est planaire.

De préférence, la deuxième couche intermédiaire 50 est perpendiculaire à la direction d'empilement Z.

La deuxième couche intermédiaire 50 est délimitée, selon la direction d'empilement Z, par la couche absorbante 35 et par la deuxième couche barrière 42.

La deuxième couche intermédiaire 50 présente une sixième épaisseur e6 selon la direction d'empilement Z.

La deuxième couche intermédiaire 50 est réalisée en le troisième matériau M3.

La deuxième couche intermédiaire 50 comporte une troisième zone intermédiaire 87 et une quatrième zone intermédiaire 90.

La troisième zone intermédiaire 87 présente un dopage du premier type.

La troisième zone intermédiaire 87 présente une neuvième densité volumique de porteurs d9.

La neuvième densité volumique de porteurs d9 est, par exemple, comprise strictement entre 1.10¹⁴/cm³ et 5.10¹⁷/cm³.

La troisième zone intermédiaire 87 et la première portion 65 sont superposées selon la direction d'empilement Z.

La troisième zone intermédiaire 87 est annulaire à base circulaire. La troisième zone intermédiaire 87 présente une symétrie circulaire autour du premier axe A1.

La troisième zone intermédiaire 87 entoure, dans un plan perpendiculaire à la direction d'empilement Z, la quatrième zone intermédiaire 90 et l'électrode primaire 55.

La quatrième zone intermédiaire 90 présente un dopage du deuxième type.

La quatrième zone intermédiaire 90 présente une dixième densité volumique de porteurs d10.

La dixième densité volumique de porteurs d10 est, par exemple, comprise strictement entre 1.10¹⁶/cm³ et 5.10¹⁸/cm³.

La quatrième zone intermédiaire 90 est annulaire à base circulaire. La quatrième zone intermédiaire 90 présente une symétrie circulaire autour du premier axe A1.

La quatrième zone intermédiaire 90 entoure, dans un plan perpendiculaire à la direction d'empilement Z, l'électrode primaire 55.

La quatrième zone intermédiaire 90 et la deuxième portion 70 sont superposées selon la direction d'empilement Z.

La troisième zone intermédiaire 87 et la quatrième zone intermédiaire 90 forment une cinquième jonction p/n J5.

La cinquième jonction p/n J5 entoure l'électrode primaire dans un plan perpendiculaire à la direction d'empilement Z.

L'électrode primaire 55 est propre à connecter électriquement la deuxième zone conductrice 80 au circuit de lecture 20. L'électrode primaire 55 est, en outre, propre à connecter électriquement la quatrième zone conductrice 82 au circuit de lecture 20.

L'électrode primaire 55 est réalisée en un matériau métallique.

L'électrode primaire 55 est, par exemple, réalisée en platine. En variante, l'électrode primaire 55 est réalisée en titane.

L'électrode primaire 55 est, par exemple, cylindrique à base circulaire autour du premier axe A1.

L'électrode primaire 55 traverse la première face 25 et la deuxième face 30. Cela signifie que l'électrode primaire 55 traverse chacune des couches de l'empilement 15.

En variante, l'électrode primaire 55 ne traverse pas la deuxième face 30.

L'électrode secondaire 57 est propre à connecter électriquement la première zone conductrice 75 au circuit de lecture 20.

L'électrode secondaire 57 est, en outre, propre à connecter électriquement la troisième zone conductrice 77 au circuit de lecture 20.

L'électrode secondaire 57 est réalisée en un matériau métallique.

L'électrode secondaire 57 est, par exemple, réalisée en platine. En variante, l'électrode secondaire 57 est réalisée en titane.

L'électrode secondaire 57 est, par exemple, cylindrique à base circulaire. L'axe de l'électrode secondaire 57 est le premier axe A1.

En variante, l'électrode secondaire 57 est conique, à base circulaire.

L'électrode secondaire 57 traverse la première surface 25. Sur la figure 1, l'électrode secondaire 57 traverse, en outre, la deuxième face 30.

La couche de passivation 60 est propre à isoler électriquement la première couche barrière 40 de l'extérieur de l'empilement 15. De préférence, la couche de passivation 60 est, en outre, propre à empêcher la première couche barrière 40 de s'oxyder au contact de l'atmosphère.

La couche de passivation 60 est planaire. La couche de passivation 60 est, de préférence, perpendiculaire à la direction d'empilement Z.

Selon la direction d'empilement Z, la couche de passivation 60 est délimitée par la première couche barrière 40 et par la couche filtrante 22.

La couche de passivation 60 est réalisée en un matériau diélectrique Md tel que l'oxyde de silicium SiOₓ ou le nitrure de silicium SiNₓ.

La couche de passivation 60 présente une septième épaisseur e7 selon la direction d'empilement Z.

Le fonctionnement de l'élément détecteur 10 va maintenant être décrit.

Une tension électrique U est appliquée entre l'électrode primaire 55 et l'électrode secondaire 57. La tension U permet de compenser la dispersion des transistors du circuit de lecture 20.

La tension électrique U est, par exemple d'un dixième de Volt (V).

L'élément détecteur de rayonnement 10 reçoit sur la deuxième face 30 un rayonnement R.

Le rayonnement R comprend au moins une première onde électromagnétique Oe1 et une deuxième onde électromagnétique Oe2.

La première onde électromagnétique Oe1 présente une première énergie en1 comprise dans l'ensemble primaire En1, et une première amplitude A1.

La deuxième onde électromagnétique Oe2 présente une deuxième énergie en2 comprise dans l'ensemble secondaire En2.

La première énergie en1 est supérieure ou égale à la première valeur de gap G1, et inférieure strictement à la deuxième valeur de gap G2 et à la troisième valeur de gap G3.

La première onde électromagnétique Oe1 se propage à travers la couche filtrante 22 puis traverse la couche de passivation 60, la première couche barrière 40 et la première couche intermédiaire 45 avant d'être absorbée par la couche absorbante 35.

La deuxième onde électromagnétique Oe2 ne se propage pas à travers la couche filtrante 22.

L'absorption de la première onde électromagnétique Oe1 dans la couche absorbante 35 génère une paire électron-trou (également appelée exciton).

La séparation de la paire électron-trou par le premier champ électrique C1 donne naissance au courant électrique C. Un tel mode de fonctionnement pour l'élément détecteur 10 est dénommé « mode photovoltaïque ».

Le courant électrique C traverse successivement l'électrode secondaire 57, la première zone conductrice 75, la première zone intermédiaire 83, la première portion 65, la deuxième portion 70 et l'électrode primaire 55.

Le courant électrique C est détecté par le circuit de lecture 20, qui génère le signal électrique S.

La première zone conductrice 75, étant fortement dopée, présente une faible résistance au passage du courant électrique C.

L'élément détecteur 10 ne comporte donc pas de couche métallique destinée à conduire le courant de la première couche barrière 40 à l'électrode secondaire 57. L'élément détecteur 10 ne présente donc pas de pertes liées à l'absorption du rayonnement R dans une telle couche métallique.

Le rendement de l'élément détecteur 10 est donc amélioré.

Un deuxième exemple d'élément détecteur 10 est représenté à la figure 2. Les éléments identiques au premier exemple de la figure 1 ne sont pas décrits à nouveau. Seules les différences sont mises en évidence.

La première couche barrière 40 ne comprend pas de deuxième zone conductrice 80. L'élément détecteur 10 ne comprend pas de deuxième jonction p/n J2.

La couche de passivation 60 est propre à isoler électriquement la première couche barrière 40 de l'électrode primaire 55.

De préférence, la couche de passivation 60 entoure, dans un plan orthogonal à la direction d'empilement Z et traversant la première couche barrière 40, l'électrode primaire 55.

La couche de passivation 60 est donc entourée, dans un plan orthogonal à la direction d'empilement Z, par la première zone conductrice 75.

Le fonctionnement du deuxième exemple est identique au fonctionnement du premier exemple.

L'élément détecteur 10 permet alors d'éviter l'apparition de courants électriques de fuite à travers la première zone conductrice 75, la deuxième zone conductrice 80, et l'électrode primaire 55.

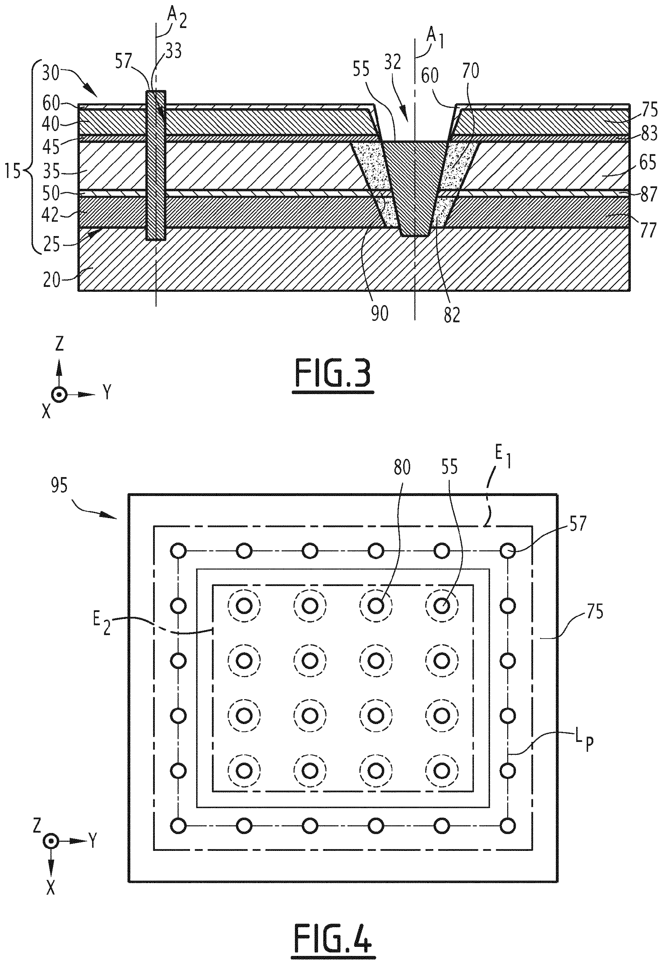

Un troisième exemple d'élément détecteur 10 est représenté sur la figure 3. Les éléments identiques au premier exemple de la figure 1 ne sont pas décrits à nouveau. Seules les différences sont mises en évidence.

Le trou primaire 32 est en forme de cône à base circulaire.

L'électrode primaire 55 traverse la deuxième couche barrière 42, la deuxième couche intermédiaire 50, et la couche absorbante 35. L'électrode primaire 55 ne traverse pas la première couche intermédiaire 50.

La couche de passivation 60 est définie, dans un plan perpendiculaire à la direction d'empilement Z, par la première couche barrière 40 et par le trou primaire 32. Cela signifie que la couche de passivation 60 recouvre en partie les parois intérieures du trou primaire 32.

Le fonctionnement du troisième exemple est identique au fonctionnement du premier exemple.

La réalisation de l'électrode primaire 55 est rendue plus aisée par la géométrie conique du trou primaire 32. La fabrication de l'élément détecteur 10 est donc facilitée.

Un premier exemple d'imageur 95 est représenté sur la figure 4.

L'imageur 95 comprend un premier ensemble E1 de trous secondaires 33 accueillant chacun au moins en partie une électrode secondaire 57, et un deuxième ensemble E2 d'éléments détecteurs 10.

Les éléments détecteurs 10 partagent un seul circuit de lecture 20. Le circuit de lecture 20 est configuré pour recevoir de chaque électrode primaire 55 un courant électrique C respectif.

Le circuit de lecture 20 est configuré pour générer, à partir de chaque courant électrique C, un signal électrique S respectif.

Le premier ensemble E1 de trous secondaires 33 présente une ligne propre Lp. Chacun des trous secondaires 33 du premier ensemble E1 est disposé le long de la ligne propre Lp.

La ligne propre Lp entoure le deuxième ensemble E2 dans un plan orthogonal à la direction d'empilement Z. La ligne propre Lp est, par exemple, rectangulaire.

Le fonctionnement de chaque élément détecteur 10 de l'imageur 95 est identique au fonctionnement du premier exemple de la figure 1.

Dans l'imageur 95, les électrodes secondaires 57 sont situées à l'extérieur du deuxième ensemble E2. Le volume de la couche absorbante 35 de chaque élément détecteur 10 est donc augmenté. Le rendement de l'imageur 95 est alors amélioré.

De plus, la résistance électrique de chaque élément détecteur est diminuée : la tension U est donc plus homogène d'un élément détecteur 10 à l'autre.

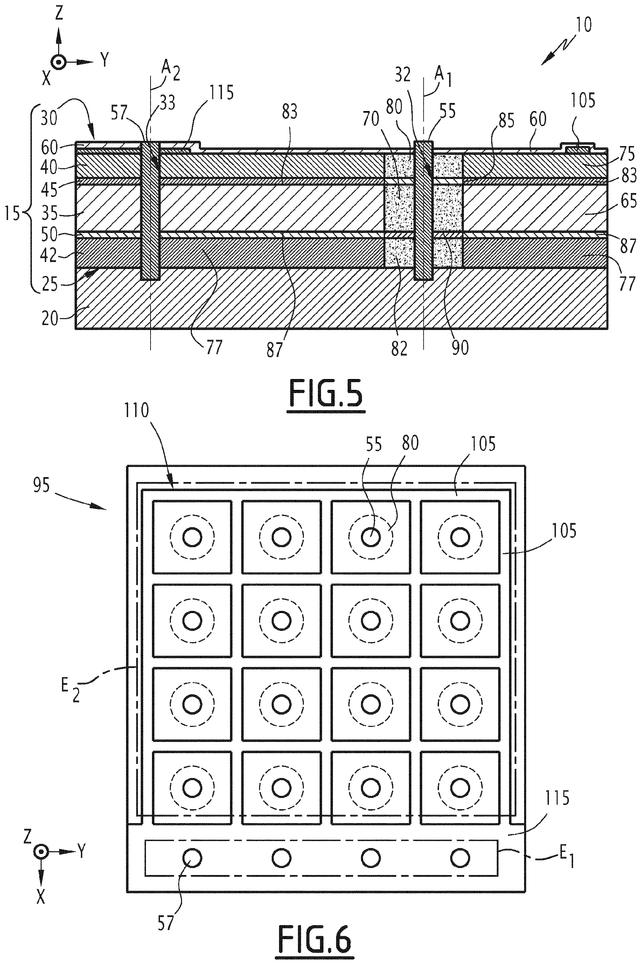

Un quatrième exemple d'élément détecteur 10 est représenté sur la figure 5. Les éléments identiques au premier exemple de la figure 1 ne sont pas décrits à nouveau. Seules les différences sont mises en évidence.

La troisième densité volumique de porteurs d3 est inférieure strictement à 5.10¹⁶/cm³. De préférence, la troisième densité volumique de porteurs d3 est égale à 2.10¹⁶/cm³.

La deuxième face 30 porte une bande 105 réalisée en le deuxième matériau M2.

La bande 105 est propre à permettre le passage du courant électrique C entre la première zone conductrice 75 et l'électrode secondaire 57.

La bande 105 présente un dopage du premier type.

La bande 105 présente une onzième densité volumique de porteurs libres d11. La onzième densité volumique de porteurs libres d11 est supérieure ou égale à 10¹⁷/cm³.

En variante, la bande 105 est réalisée en un matériau semi-conducteur dégénéré.

La bande 105 est connectée électriquement à au moins une électrode secondaire 57.

La bande 105 présente une huitième épaisseur e8 selon la direction d'empilement Z.

La huitième épaisseur e8 est, par exemple, comprise strictement entre 500 nm et 5 µm.

La bande 105 présente une première largeur L1 dans un plan perpendiculaire à la direction Z.

La bande 105 et la première zone conductrice 75 sont superposées selon la direction d'empilement Z.

La bande 105 est délimitée, selon la direction d'empilement Z, par la première zone conductrice 75 et par la couche de passivation 60.

La bande 105 est connectée électriquement à la première zone conductrice 75.

La bande 105 est rectiligne, comme visible sur la figure 6. La bande 105 s'étend dans un plan orthogonal à la direction d'empilement Z.

La couche de passivation 60 est propre à isoler électriquement la bande 105 de l'extérieur de l'empilement 15. Cela signifie que la couche de passivation recouvre en totalité la bande 105.

Le fonctionnement du quatrième exemple va maintenant être décrit.

Le courant électrique C traverse successivement une électrode secondaire 57, la bande 105, la première zone conductrice 75, la première zone intermédiaire 83, la première portion 65, la deuxième portion 70 et l'électrode primaire 55.

La première zone conductrice 75 présente une densité de porteurs inférieure ou égale à 5.10¹⁶/cm³. Les courants de fuite à travers la deuxième jonction p/n j2 sont alors réduits.

Le rendement de l'élément détecteur 10 est alors amélioré.

De plus, la réalisation de l'élément détecteur 10 est facilitée.

Un deuxième exemple d'imageur 95 est représenté sur la figure 6. Les éléments identiques au premier exemple d'imageur de la figure 4 ne sont pas décrits à nouveau. Seules les différences sont mises en évidence.

Au moins un élément détecteur 10 est conforme au quatrième exemple d'élément détecteur de la figure 5. De préférence, chaque élément détecteur 10 est conforme au quatrième exemple d'élément détecteur de la figure 5.

Chaque bande 105 est connectée électriquement à au moins une autre bande 105.

Les bandes 105 forment un réseau 110 bidimensionnel sur la deuxième face 30.

Le réseau 110 présente une pluralité de mailles M.

Chaque maille M est formée par quatre bandes 105 s'entrecroisant. Cela signifie que les quatre bandes 105 forment, sur la deuxième surface 30, une boucle fermée.

Chaque maille M entoure au moins une électrode primaire 55. De préférence, chaque maille M entoure une unique électrode primaire 55.

Le réseau 110 est un réseau rectangulaire. Cela signifie que les bandes 105 sont perpendiculaires entre elles.

Il est entendu par « perpendiculaire » que l'angle formé par deux bandes 105 s'entrecroisant est égal à quatre-vingt-dix degrés, à cinq degrés près.

Le réseau 110 comprend, en outre, une couche de collection 115.

La couche de collection 115 est propre à permettre le passage du courant électrique C entre au moins une bande 105 et au moins une électrode secondaire 57.

La couche de collection 115 recouvre en partie la deuxième face 30. La couche de collection 115 est délimitée, selon la direction d'empilement Z, par la deuxième face 30.

La couche de collection 115 est, par exemple, rectangulaire.

La couche de collection 115 est plane, et s'étend dans un plan perpendiculaire à la direction d'empilement Z.

La couche de collection 115 est réalisée en le deuxième matériau M2.

La couche de collection 115 présente un dopage du premier type.

La couche de collection 115 présente une douzième densité volumique de porteurs libres d12. La douzième densité volumique de porteurs libres d12 est supérieure ou égale à 10¹⁷/cm³.

La couche de collection 115 est connectée électriquement à au moins une bande 105. De préférence, la couche de collection 115 est connectée électriquement à chaque bande 105.

La couche de collection 115 est connectée électriquement à au moins une électrode secondaire 57. De préférence, chaque trou secondaire 33 du premier ensemble E1 traverse la couche de collection 115.

Chaque électrode secondaire 57 connecte électriquement la couche de collection 115 au circuit de lecture 20.

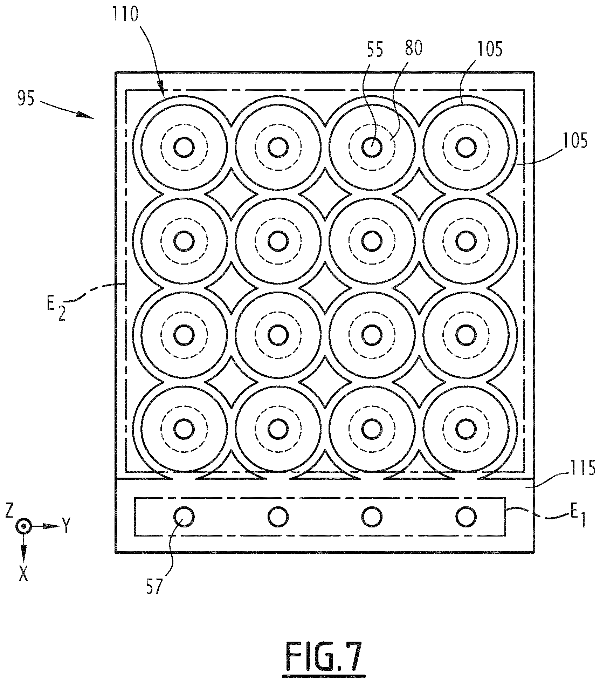

Dans une variante représentée sur la figure 7, la bande 105 entoure l'électrode primaire 55 dans un plan perpendiculaire à la direction d'empilement Z. De préférence, la bande 105 est réalisée en forme d'un anneau à base circulaire autour du premier axe A1.

Le fonctionnement du deuxième exemple d'imageur 95 va maintenant être décrit.

Le courant électrique C traverse successivement une électrode secondaire 57, la couche de collection 115, au moins une bande 105, la première zone conductrice 75, la première zone intermédiaire 83, la première portion 65, la deuxième portion 70 et l'électrode primaire 55.

La première zone conductrice 75 de chaque détecteur 10 présente une densité de porteurs inférieure ou égale à 5.10¹⁶/cm³. La fabrication de l'imageur 95 est donc facilitée.

Dans chacun des exemples donnés ci-dessus, la première zone conductrice 75 présente une conductivité électrique élevée, de l'ordre de un siemens par centimètre.

La résistance électrique de chaque élément détecteur 10 est donc diminuée, et la tension U est plus homogène d'un élément détecteur 10 à l'autre. L'imageur 95 est donc plus précis.

De plus, la deuxième face 30 ne comporte pas de couche métallique. L'imageur 95 ne présente donc pas de pertes causées par l'absorption du rayonnement R par une telle couche métallique.

Le rendement de l'imageur 95 et des éléments détecteurs 10 est donc augmenté.

## Revendications

1. Un élément (10) détecteur de rayonnements comprenant :
- un empilement (15) de couches superposées selon une direction d'empilement (Z), l'empilement (15) présentant une première face (25) et une deuxième face (30) et comprenant une couche absorbante de rayonnement (35) réalisée en un premier matériau semi-conducteur (M1) présentant une première valeur de gap et au moins une couche barrière (40) réalisée en un deuxième matériau semi-conducteur (M2) présentant une deuxième valeur de gap, la deuxième valeur de gap étant supérieure strictement à la première valeur de gap ; et
- un circuit de lecture (20) délimité selon la direction d'empilement (Z) par la première face (25) ;
la couche absorbante (35) comprenant une première portion (65) présentant un dopage d'un premier type choisi parmi le dopage de type n et le dopage de type p, et une deuxième portion (70) présentant un dopage d'un deuxième type choisi parmi le dopage de type n et le dopage de type p, le deuxième type de dopage étant différent du premier type de dopage, la première portion (65) et la deuxième portion (70) formant une première jonction p-n ;
l'empilement (15) délimitant en outre un trou primaire (32) traversant chacune des couches de l'empilement (15), le trou primaire (32) accueillant au moins en partie une électrode primaire (55) connectant électriquement la deuxième portion (70) au circuit de lecture (20) et traversant la première face (25), la première jonction p-n entourant l'électrode primaire (55) dans un plan orthogonal à la direction d'empilement (Z), **caractérisé par** la deuxième face (30) portant au moins une bande (105) délimitée selon la direction d'empilement (Z) par la couche barrière (40), la bande (105) étant réalisée en le deuxième matériau semi-conducteur (M2) et présentant un dopage du premier type et une densité de porteurs libres supérieure ou égale à 1.10¹⁷cm⁻³.

2. Elément détecteur de rayonnement selon la revendication 1, dans lequel la bande (105) est réalisée en un matériau semi-conducteur dégénéré.

3. Elément détecteur de rayonnement selon la revendication 1 ou 2, dans lequel la bande (105) entoure l'électrode primaire (55) dans un plan orthogonal à la direction d'empilement (Z).

4. Elément détecteur de rayonnement selon l'une quelconque des revendication 1 à 3, dans lequel l'empilement (15) comprend, en outre, au moins une couche intermédiaire (45) réalisée en un troisième matériau semi-conducteur (M3) ayant une troisième valeur de gap (G3) comprise entre la première valeur de gap et la deuxième valeur de gap, la couche intermédiaire (45) étant délimitée, selon la direction d'empilement (Z), par la couche absorbante (35) et la couche barrière (40).

5. Elément détecteur de rayonnement selon la revendication 4, dans lequel le troisième matériau (M3) est un matériau quaternaire au moins formé à partir du premier matériau (M1) et du deuxième matériau (M2).

6. Elément détecteur de rayonnement selon l'une quelconque des revendications 1 à 5, dans lequel le premier matériau (M1) est choisi parmi InGaAs, InAsSb et InSb, et
- lorsque le premier matériau (M1) est InGaAs, le deuxième matériau (M2) est InP ;
- lorsque le premier matériau (M1) est InAsSb, le deuxième matériau (M2) est AIGaAsSb ; et
- lorsque le premier matériau (M1) est InSb, le deuxième matériau (M2) est InAISb.

7. Elément détecteur de rayonnement selon l'une quelconque des revendications 1 à 6, comportant en outre une couche de passivation (60) entourant dans un plan orthogonal à la direction d'empilement (Z) l'électrode primaire (55), la couche de passivation étant délimitée dans le plan orthogonal à la direction d'empilement (Z) par l'électrode primaire (55) et par la couche barrière (40), la couche de passivation (60) étant propre à isoler électriquement la couche barrière (40) de l'électrode primaire (55).

8. Elément détecteur de rayonnement selon l'une quelconque des revendications 1 à 7, comportant en outre une couche filtrante (22) propre à permettre la propagation d'au moins une onde électromagnétique présentant une première énergie comprise dans un ensemble primaire d'énergies et à empêcher la propagation d'au moins une onde électromagnétique présentant une deuxième énergie comprise dans un ensemble secondaire d'énergies, l'ensemble secondaire étant différent de l'ensemble primaire, la couche filtrante (22) étant délimitée selon la direction d'empilement (Z) par la deuxième face (30).

9. Elément détecteur de rayonnement selon l'une quelconque des revendications 1 à 8, dans lequel le trou primaire (32) est en forme de cône à base circulaire.

10. Imageur (95) comprenant au moins un deuxième ensemble (E2) d'éléments détecteurs de rayonnements (10) selon l'une quelconque des revendications 1 à 9,
dans lequel chaque bande (105) est connectée électriquement à au moins une autre bande (105), les bandes (105) formant, sur la deuxième face (30), un réseau (110) bidimensionnel présentant une pluralité de mailles, chaque maille entourant, dans un plan orthogonal à la direction d'empilement (Z), une unique électrode primaire (55).

11. Imageur (95) selon la revendication 10, dans lequel le réseau comprend une couche de collection (115) réalisée en le deuxième matériau (M2), et recouvrant en partie la deuxième face (30), l'imageur (95) comprenant, en outre, un ensemble (E1) de trous secondaires (33), chaque trou secondaire (33) traversant la couche de collection (115) et accueillant au moins en partie une électrode secondaire (57) traversant la première face (25) et connectant électriquement la couche de collection (115) au circuit de lecture (20).

## Patentansprüche

1. Ein Element (10) zum Detektieren von Strahlung, welches aufweist:
- einen Stapel (15) von Schichten, welche entlang einer Stapelrichtung (Z) gestapelt sind, wobei der Stapel (15) eine erste Fläche (25) und eine zweite Fläche (30) hat und aufweist eine Strahlungsabsorptionsschicht (35), welche aus einem ersten Halbleitermaterial (M1) gebildet ist, welches einen ersten Lückenwert hat, und mindestens eine Barriereschicht (40), welche aus einem zweiten Halbleitermaterial (M2) gebildet ist, welches einen zweiten Lückenwert hat, wobei der zweite Lückenwert strikt größer ist als der erste Lückenwert, und
- einen Leseschaltkreis (20), welcher entlang der Stapelrichtung (Z) mittels der ersten Fläche (25) begrenzt ist,
wobei die Absorptionsschicht (35) aufweist einen ersten Abschnitt (65), welcher eine Dotierung eines ersten Typs hat, welcher ausgewählt ist aus der n-Typ-Dotierung und der p-Typ-Dotierung, und einen zweiten Abschnitt (70), welcher eine Dotierung eines zweiten Typs hat, welcher ausgewählt ist aus der n-Typ-Dotierung und der p-Typ-Dotierung, wobei der zweite Dotierungstyp verschieden vom ersten Dotierungstyp ist, wobei der erste Abschnitt (65) und der zweite Abschnitt (70) einen ersten p-n-Übergang bilden,
wobei der Stapel (15) ferner ein primäres Loch (32) begrenzt, welches jede der Schichten des Stapels (15) durchdringt, wobei das primäre Loch (32) zumindest zum Teil eine primäre Elektrode (55) unterbringt, welche den zweiten Abschnitt (70) mit dem Leseschaltkreis (20) elektrisch verbindet und die erste Fläche (25) durchdringt, wobei der erste p-n-Übergang die primäre Elektrode (55) in einer Ebene umgibt, welche senkrecht zur Stapelrichtung (Z) ist, **gekennzeichnet dadurch, dass**
die zweite Fläche (30) mindestens ein Band (105) trägt, welches entlang der Stapelrichtung (Z) mittels der Barriereschicht (40) begrenzt ist, wobei das Band (105) aus dem zweiten Halbleitermaterial (M2) gebildet ist und eine Dotierung des ersten Typs sowie eine Freie-Ladungsträger-Dichte hat, welche größer oder gleich 1.10¹⁷cm⁻³ ist.

2. Strahlungsdetektorelement gemäß Anspruch 1, wobei das Band (105) aus einem Entarteter-Halbleiter-Material gebildet ist.

3. Strahlungsdetektorelement gemäß Anspruch 1 oder 2, wobei das Band (105) die primäre Elektrode (55) in einer Ebene umgibt, welche senkrecht zur Stapelrichtung (Z) ist.

4. Strahlungsdetektorelement gemäß irgendeinem der Ansprüche 1 bis 3, wobei der Stapel (15) ferner aufweist mindestens eine Zwischenschicht (45), welche aus einem dritten Halbleitermaterial (M3) gebildet ist, welches einen dritten Lückenwert (G3) hat, welcher zwischen dem ersten Lückenwert und dem zweiten Lückenwert liegt, wobei die Zwischenschicht (45) entlang der Stapelrichtung (Z) mittels der Absorptionsschicht (35) und der Barriereschicht (40) begrenzt ist.

5. Strahlungsdetektorelement gemäß Anspruch 4, wobei das dritte Material (M3) ein quartäres Material ist, welches zumindest gebildet ist ausgehend von dem ersten Material (M1) und von dem zweiten Material (M2).

6. Strahlungsdetektorelement gemäß irgendeinem der Ansprüche 1 bis 5, wobei das erste Material (M1) ausgewählt ist aus InGaAs, InAsSb und InSb und,
- wenn das erste Material (M1) InGaAs ist, das zweite Material (M2) InP ist,
- wenn das erste Material (M1) InAsSb ist, das zweite Material (M2) AIGaAsSb ist, und
- wenn das erste Material (M1) InSb ist, das zweite Material (M2) InAISb ist.

7. Strahlungsdetektorelement gemäß irgendeinem der Ansprüche 1 bis 6, welches ferner eine Passivationsschicht (60) aufweist, welche in einer Ebene, welche senkrecht zur Stapelrichtung (Z) ist, die primäre Elektrode (55) umgibt, wobei die Passivationsschicht in der Ebene, welche senkrecht zur Stapelrichtung (Z) ist, mittels der primären Elektrode (55) und mittels der Barriereschicht (40) begrenzt ist, wobei die Passivationsschicht (60) imstande ist, die Barriereschicht (40) von der primären Elektrode (55) elektrisch zu isolieren.

8. Strahlungsdetektorelement gemäß irgendeinem der Ansprüche 1 bis 7, welches ferner eine Filterschicht (22) aufweist, welche imstande ist, die Ausbreitung von mindestens einer elektromagnetischen Welle zu erlauben, welche eine erste Energie hat, welche in einer primären Gruppe von Energien enthalten ist, und die Ausbreitung von mindestens einer elektromagnetischen Welle zu verhindern, welche ein zweite Energie hat, welche in einer sekundären Gruppe von Energien enthalten ist, wobei die sekundäre Gruppe verschieden von der primären Gruppe ist, wobei die Filterschicht (22) entlang der Stapelrichtung (Z) mittels der zweiten Fläche (30) begrenzt ist.

9. Strahlungsdetektorelement gemäß irgendeinem der Ansprüche 1 bis 8, wobei das primäre Loch (32) konusförmig mit kreisförmiger Basis ist.

10. Bildgeber (95), welcher mindestens eine zweite Gruppe (E2) von Strahlungsdetektorelementen (10) gemäß irgendeinem der Ansprüche 1 bis 9 aufweist,
wobei jedes Band (105) mit mindestens einem anderen Band (105) elektrisch verbunden ist, wobei die Bänder (105) auf der zweiten Fläche (30) ein zweidimensionales Netz (110) bilden, welches eine Mehrzahl von Maschen hat, wobei jede Masche in einer Ebene, welche senkrecht zur Stapelrichtung (Z) ist, eine einzelne primäre Elektrode (55) bildet.

11. Bildgeber (95) gemäß Anspruch 10, wobei das Netz eine Sammelschicht (115) aufweist, welche aus dem zweiten Material (M2) gebildet ist, und zum Teil die zweite Fläche (30) bedeckt, wobei der Bildgeber (95) ferner eine Gruppe von sekundären Löchern (33) aufweist, wobei jedes sekundäre Loch (33) die Sammelschicht (115) durchdringt und zumindest zum Teil eine sekundäre Elektrode (57) unterbringt, welche die erste Fläche (25) durchdringt und die Sammelschicht (115) mit dem Leseschaltkreis (20) elektrisch verbindet.

## Claims

1. A radiation detector element (10) comprising:
- a stack (15) of layers superimposed in a stacking direction (Z), the stack (15) having a first face (25) and a second face (30) and comprising a radiation-absorbing layer (35) consisting of a first semiconductor material (M1) having a first band gap value and at least one barrier layer (40) consisting of a second semiconductor material (M2) having a second band gap value, the second band gap value being strictly greater than the first band gap value; and
- a reading circuit (20) delimited in the stacking direction (Z) by the first face (25); the absorbing layer (35) comprising a first portion (65) having a doping of a first type chosen from among n-type doping and p-type doping, and a second portion (70) having a doping of a second type chosen from among n-type doping and p-type doping, the second type of doping being different from the first type of doping, the first portion (65) and the second portion (70) forming a first p-n junction;
the stack (15) further delimiting a primary hole (32) traversing each of the layers of the stack (15), the primary hole (32) receiving at least part of a primary electrode (55) electrically connecting the second portion (70) to the reading circuit (20) and traversing the first face (25), the first p-n junction surrounding the primary electrode (55) in a plane orthogonal to the stacking direction (Z), and
the second face (30) carrying at least one band (105) delimited in the stacking direction (Z) by the barrier layer (40), the band (105) being made from the second semiconductor material (M2) and having a doping of the first type and a free carrier density greater than or equal to 1.10¹⁷ cm⁻³.

2. The radiation detector element according to claim 1, wherein the band (105) is made from a degenerated semiconductor material.

3. The radiation detector element according to claim 1 or 2, wherein the band (105) surrounds the primary electrode (55) in a plane orthogonal to the stacking direction (Z).

4. The radiation detector element according to any one of claims 1 to 3, wherein the stack (15) further comprises at least one intermediate layer (45) made from a third semiconductor material (M3) having a third band gap value (G3) comprised between the first band gap value and the second band gap value, the intermediate layer (45) being delimited, in the stacking direction (Z), by the absorbing layer (35) and the barrier layer (40).

5. The radiation detector element according to claim 4, wherein the third material (M3) is a quaternary material at least formed from the first material (M1) and the second material (M2).

6. The radiation detector element according to any one of claims 1 to 5, wherein the first material (M1) is chosen from among InGaAs, InAsSb and InSb, and
- when the first material (M1) is InGaAs, the second material (M2) is InP;
- when the first material (M1) is InAsSb, the second material (M2) is AIGaAsSb; and
- when the first material (M1) is InSb, the second material (M2) is InAISb.

7. The radiation detector element according to any one of claims 1 to 6, further including a passivation layer (60) surrounding the primary electrode (55) in a plane orthogonal to the stacking direction (Z), the passivation layer being delimited in the plane orthogonal to the stacking direction (Z) by the primary electrode (55) and by the barrier layer (40), the passivation layer (60) being able to electrically isolate the barrier layer (40) from the primary electrode (55).

8. The radiation detector element according to any one of claims 1 to 7, further including a filtering layer (22) able to allow the propagation of at least one electromagnetic wave having a first energy comprised in a primary set of energies and to prevent the propagation of at least one electromagnetic wave having a second energy comprised in a secondary set of energies, the secondary set being different from the primary set, the filtering layer (22) being delimited in the stacking direction (Z) by the second face (30).

9. The radiation detection element according to any one of claims 1 to 8, wherein the primary hole (32) is cone-shaped with a circular base.

10. An imager (95) comprising at least one second set (E2) of radiation detector elements (10) according to any one of claims 1 to 9,
wherein each band (105) is electrically connected to at least one other band (105), the bands (105) forming, on the second face (30), a two-dimensional array (110) having a plurality of meshes, each mesh surrounding, in a plane orthogonal to the stacking direction (Z), a single primary electrode (55).

11. The imager (95) according to claim 10, wherein the array comprises a collection layer (115) made from the second material (M2), and partly covering the second face (30), the imager (95) further comprising a set (E1) of secondary holes (33), each secondary hole (33) traversing the collection layer (115) and at least partially receiving a secondary electrode (57) traversing the first face (25) and electrically connecting the collection layer (115) to the reading circuit (20).
